Europäisches Patentamt

European Patent Office

Office européen des brevets

(11) Publication number: **0 445 441 A1**

# EUROPEAN PATENT APPLICATION

(21) Application number: **90203442.0**

(22) Date of filing: **21.12.90**

(51) Int. Cl.⁵: **G01P 5/08, G01C 19/14**

(30) Priority: **23.01.90 NL 9000163**

(43) Date of publication of application:
**11.09.91 Bulletin 91/37**

(84) Designated Contracting States:
**BE CH DE DK ES FR GB GR IT LI NL SE**

(71) Applicant: **Datawell B.V.**
**Zomerluststraat 4**
**NL-2012 LM Haarlem(NL)**

(72) Inventor: **Rademakers, Petrus Johannes, Ir.**
**Bellamylaan 1**
**NL-2111 CH Aerdenhout(NL)**

(74) Representative: **de Wit, Gerard Frederik, Ir. et al**
**Octrooi- en Merkenbureau De Wit B.V.**
**Breitnerlaan 146**
**NL-2596 HG Den Haag(NL)**

(54) **Angular rate sensor.**

(57) Angular rate sensor provided with a liquid inertial mass (1), preferably of mercury, which can rotate with respect to a vessel in which it is contained, a magnetic field passing through said inertial mass and electrode pairs (4,2; 37,38,39), said inertial mass being spherical and one electrode (4) of each pair of electrodes between which a voltage is measured is located in the centre of the sphere and/or in which the direction of the magnetic field is invariable in space.

fig. 6

## ANGULAR RATE SENSOR.

The invention relates to an angular rate sensor for a movable system provided with an electrically conducting inertial mass through which an almost homogeneous magnet field passes, which mass is rotatable with respect to the system but translatively fixedly connected to it, wherewith at least one pair of electrodes contact said mass, which electrodes are fixedly connected to the system and are spaced apart by a distance, the electrode vector, and by means of conductors are connected to a receiving device.

Such an angular rate sensor is known from "Final Report for Period 20 February 1978 - 30 December 1978 Contract No. DNA002-78-C-0126" of R.E.Weber, The Singer Company, Kearfott Division at Fairfield, New Jersey 07006.

In this known angular rate sensor the magnet field is generated by a magnet, which is fixedly connected to the system. Moreover with this angular rate sensor only the angular rate about one axis can be determined, which is fixedly connected to the system. This leads to a number of disadvantages.

A first one of them is, that the use of such an angular rate sensor becomes very complicated with determining angular rates in space, for instance about three mutually perpendicular axes, but moreover the disadvantage occurs that, as will be elucidated further in this specification, with determining the angular position from the angular rate about axes which move along with the system different results can be obtained, dependent on the sequence in time of the different angular rates.

The invention aims in different embodiments to eliminate at least one if not both of the two indicated disadvantages, at least reduce them considerably.

According to a first aspect of the invention it is accordingly provided that the magnet field has a direction in space which is independent of the angular position of the system in space. As will be further indicated in this specification by applying of this feature it can be obtained, that, independently from the orientation of the system the angular rate of the system about this independent direction is determined, which among others has the advantage that a lower sampling rate will do.

It is possible to obtain a magnet field, which has a fixed direction in space by coupling means for generating a magnet field such as permanent magnets with a gyroscope.

This embodiment of the invention is, however, relatively complicated and has with certain applications, such as position and direction determining in measuring buoys for oceanographic research, the disadvantage, that it is difficult to keep a gyroscope running without adjustment or service during a number of years, wherewith specially in such a long time lapse hardly the occurrence of drift can be avoided, even with drift compensated gyroscopes as for instance are known from the U.S. Patent Specification 4 270 387.

According to a further elaboration of the invention it is provided that it contains three or more electrode pairs, which together form the base of a three-dimensional space. As will be shown further on with three electrode pairs a result can be obtained, which consists in the angular rate about the direction of a magnet field in space.

Though three electrode pairs are sufficient for an unambiguous angular rate determination in space it may have the advantage to use more than three electrode pairs, wherewith the occurrence of redundancy may have advantages.

A preferred embodiment of the invention, which is relatively simple, provides that three electrode vectors are present which are mutually perpendicular, wherewith the inertial mass may consist in a liquid in a spherical vessel, wherewith as liquid in agreement with the above mentioned report, mercury may be used. Mercury has by its large electrical conductivity and its very small kinematical viscosity important advantages when applied in an angular rate sensor of the type of the invention.

In the already mentioned U.S. Patent Specification 4 270 387 use is made of a liquid inertial mass. This is, however, contained in an annular space and is brought into fast rotation by electro-magnetic means in order to may serve as a gyro mass.

The British Patent Specification GB 1 219 890 describes a gyroscope with a body of conducting liquid, especially mercury, which is put into rotation in a spherical vessel in order to may serve as gyroscopic inertial body.

According to a further elaboration of the invention it can be provided that one of the electrodes of each pair is near to the centre of the sphere and the other near to the wall of the sphere.

In this way an angular rate sensor is obtained, which has a simple surveyable construction.

It has appeared that with rotation about the direction of a magnet field, which direction is known, the rotation of the system about this direction is given by the scalar sum of the voltages which occur between the electrodes of the three pairs.

If one wants when applying the invention to use for the direction of the magnetic field, which is independent on the angular position of the system in space, the earth field, it is possible to provide, that the system is fixedly connected to a magnetic pick-up for measuring three mutually perpendicular components of the earth field and that the angular rate sensor is provided with magnetic energizing means generating a magnetic field in the inertial mass having the same direction as the earth field. This yields not only the advantage that the earth field is amplified or can be changed into an alternating field, but moreover it is now possible to measure the earth field in a location, where possible disturbances of the magnetic field are limited, such as for instance the top of a ship's mast.

From U.S.-A-3 614 816 it is known per se to measure a magnetic field in two mutually perpendicular directions in order to determine the correct direction of the velocity component which are obtained by means of an electro-magnetic liquid velocity measurement.

There may, however, occur cases in which measuring angular rates about an axis independently of the system is not important. In that instance the invention provides an considerable improvement with respect to the technics known from the said publication of R.E.Weber by providing an angular rate sensor provided with an electrically conducting liquid mass, which can rotate with respect to a movable system, but translatively is fixedly connected to it, members for generating a magnet field fixedly connected to the system and at least one electrode pair, the electrodes of which are spaced apart in space by a distance, the electrode vector, which according to a further aspect of the invention is characterized in that the liquid mass has the shape of a sphere, that at least three electrode pairs are present and that of each pair one electrode is near to the centre of the sphere and one near to the wall of the sphere.

Further it has appeared, that with both embodiments of the invention it may be advantageous if the generated magnet field is an alternating field.

In that instance the electrode impedance in a relatively simple way can be adapted in such a way to the measuring device by means of a transformer, that minimum influence of noise on the measuring device is obtained. Then one can, if it is desired to measure separately rotations about different axes moving with the system, make use of different frequencies of the alternating field in the different energizers.

In case a magnet field and especially an alternating field is generated, the possibility exists that the loops formed by the conductors which run from the electrodes to the receiving devices and/or a measuring device can pick up signals, which cannot be neglected in comparison with the mostly relatively weak signal which is obtained as measuring signal.

Accordingly it may be provided according to a further elaboration of the invention, that the conductors which connect an electrode pair with an auxiliary transformer of a measuring device and also the primary windings of this transformer themselves are carried out coaxially, by reason of which a minimum of magnetically induced disturbance voltage is obtained.

In the following the invention is further elucidated on hand of the drawing, in which:

fig. 1 is a scheme to elucidate rotations in different successions;

fig. 2 is a vector diagram;

fig. 3 shows schematically the velocity distribution of a liquid in an oscillating sphere;

fig. 4 shows the position of a single electrode pair;

fig. 5 is a scheme to elucidate the generation of a magnet field with the direction of an external field; and

fig. 6 shows a scheme of a complete device according to the invention.

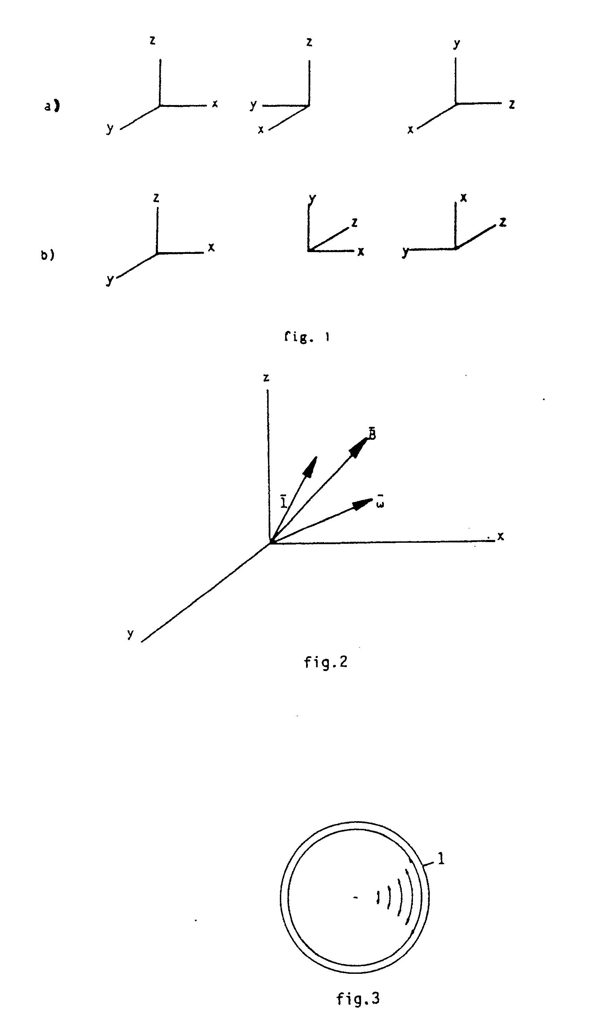

In fig. 1 with 1a a rotation of an axes system is indicated, first 90° about the z axis and after that 90° about the x axis.

In fig. 1b the same rotations have been applied, but in reversed succession. The final result differs completely from that of 1a.

If only the complete rotations about z, x and y during $\Delta t$ are known, the final result will be unknown. Therefor one should know the angular rotations about the axes as function of the time.

The supposition, that the angular rotations occurred with constant angular rate during $\Delta t$ is only justified if $\Delta t$ is small in comparison with the period of the highest angular rotation frequency. Consequently for a reliable result an extremely small value of $\Delta t$ would be necessary, which means a very high sample rate frequency.

In the following on hand of fig. 2 is elucidated which voltage signal is obtained with a predetermined magnet field in dependence on the angular rate.

If a load Q moves with a relatively velocity V through a magnet field B on the carrier of the load a force K will be exerted, which is proportional to the product $QBV\sin\phi$ in which $\phi$ is the angle between the load velocity and B, and this force is perpendicular to B and V of in vector notation:

$$K = Q.B \times V$$

The electrical field strength F, the force per coulomb consequently is

$$F = B \times V$$

Consider the axes system x y z indicated in fig. 2. Suppose the angular rate of this system is indicated by the vector w. The magnet field is indicated by the vector B.

The force per coulomb exerted on a load carrier which is located on the location vector l which rotates together with x y z, is then:

$$F = B \times (w \times l)$$

The volge difference V between the beginning and the end of the location vector equals:

$$V = \int_0^1 [B \times (w \times 1)].dl$$

$$= \int_0^1 ((w \times 1) \times dl).B$$

$$= \int_0^1 B.1 \; w.dl - B.w \; dl.1$$

We now consider the sum of the voltage differences over three location vectors $l_{xm}$, $l_{ym}$, and $l_{zm}$ coinciding with the x y and z axis respectively.

If we indicate the components of B and w in the direction of the x, y and z axis with x, y, z indices respectively, then we obtain for the sum voltage $V_S$:

$$V_S = V_{1xm} + V_{1ym} + V_{1zm}$$

$$= \int_0^{1_{xm}} B_x 1_x \omega_x dl_x + \int_0^{1_{ym}} B_y 1_y \omega_y dl_y + \int_0^{1_{zm}} B_z 1_z \omega_z dl_z$$

$$- \int_0^{1_{xm}} B.w \; 1_x dl_x - \int_0^{1_{ym}} B.w \; 1_y dl_y - \int_0^{1_{zm}} B.w \; 1_z dl_z$$

If the B field is homogeneous, $B_X$, $B_Y$ and $B_Z$ are independent of x y z and $l_{xm} = l_{Ym} = l_{zm} = 1$ then:

$$V_s = (B_x \omega_x + B_y \omega_y + B_z \omega_z) \; 0.5 \; l^2 - B. \; w \; 3 \; l^2/2 = -B.wl^2$$

Consequently $V_S$ equals $-Bl^2$ times the angular rate about the magnet vector B.

Summarizing it can be said that, if in a perpendicular coordinates system x y and z the voltage of the points 1,0,0, 0,1,0 and 0,0,1 with respect to the origin are added (scalarly), this gives a total value which is proportional to that of the (homogeneous) magnet field B, the length $l^2$ and the angular rate $\omega$ of the magnet vector B.

To obtain a signal it has to be looked for that the conductive mass does not move along with the system. Therefor it is referred to fig. 3. If the vessel I shown there is completely filled with liquid, preferably mercury, the liquid cannot carry out translative movements with respect of the system.

If, however, the vessel oscillates about a centre line, the liquid immediately near the wall will completely follow, but due to inertia of the mass the oscillations of the liquid will decrease fastly as function of the distance to the wall in inward bound direction.

If the wall of the sphere oscillates with an angular frequency $\sigma$ then the function of the decrease will equal

$$\frac{R^2}{r^2} e^{-((R-r)/\delta)}$$

in which
R = the radius of the sphere wall
r = the distance of the considered point from the centre of the sphere
$\delta$ = the penetration depth

$$\delta = +\sqrt{(2\nu/\sigma)}$$

in which $\nu$ is the kinematical viscosity of the liquid. Vide H. Lamb "Hydrodynamics" sixth Revised Edition, N.Y. 1945, par. 354.

If we choose as liquid mercury, the penetration depth becomes

($\nu_{kwik}$ is .114 $10^{-6}$ $m^2/sec$)

$$\delta = \sqrt{(.228/\sigma)} \text{ mm}$$

To get an impression for a frequency of .1 Hz is $\delta \sim$ .6mm Dependent on the desired frequency region and the desired accuracy a distance $\Delta$ with respect to the wall can be determined, such that within R-$\Delta$ the liquid can be considered to be at a stand still.

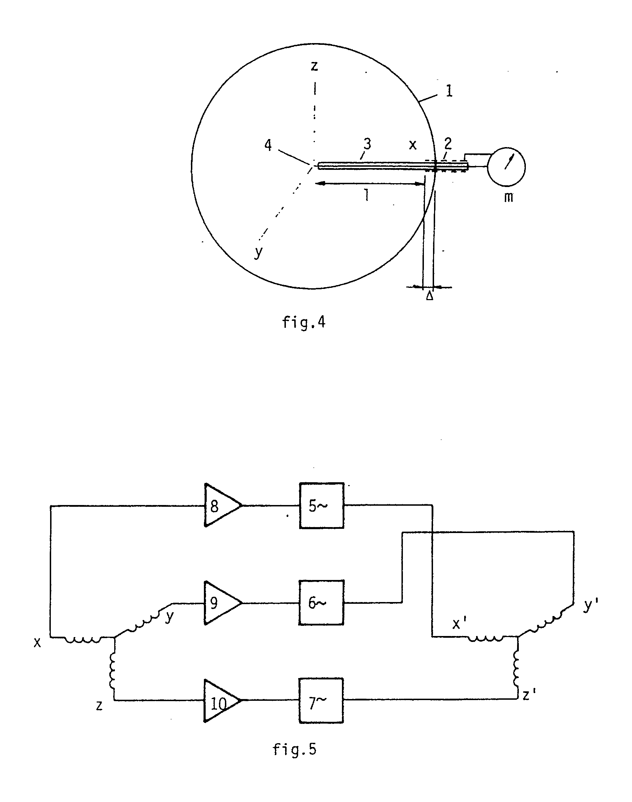

In fig. 4 schematically a preferred mounting of an electrode pair has been shown in a spherical vessel, which is filled with mercury. Along the x axis runs a coaxial cable consisting of a conducting outer sheath 2, an insulating sheath 3 and a core of a conducting wire 4. The outer sheath protrudes from the outside over a small distance $\Delta$ into the sphere. De central wire 4 goes on until near to the centre of the sphere, wherewith at that side a small bit of insulation has been removed, so that the inner wire 4 at that location contacts the mercury. The outer sheath also contacts over a small distance $\Delta$ the mercury, so that a circuit 4 - mercury - 2 is closed via the non-moving mercury. When the system and consequently the sphere I rotates, the conductor 4 will move in the magnet field that goes through the sphere and consequently will generate an electro-motoric force. This equals 0,5 $B\omega l^2$ if the magnet field runs in the direction of the z axis and the system rotates about this with the angular rate $\omega$.

In a complete system a unit analoguous to the unit 2, 3, 4 is mounted in the y axis and the z axis. The sum of the signals is then equal to $B\omega l^2$, regardless the orientation of the B vector in the x-y-z-system.

Fig. 5 shows a scheme enabling to transform a magnet field into an alternating field with the same direction. Pick-up elements indicated with the mutual perpendicular axes x, y and z control amplifiers 8, 9 and 10, which via modulators 5, 6 and 7 energize the coils indicated with x', y' and z' for generating a magnet field which passes through the mercury mass.

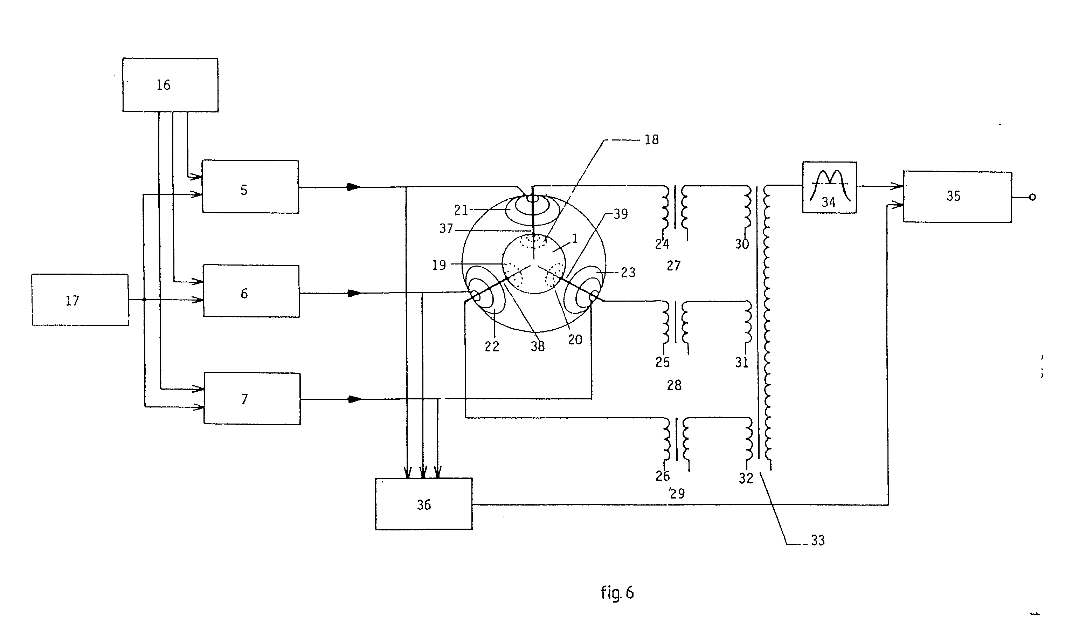

Finally in fig. 6 a scheme has been given of a complete device according to the invention. 16 indicates a magnetic pick-up which is fixedly coupled to the movable system and preferably is located at a location where the directional field, normally the earth field, has not been disturbed by parts of the system itself. Further an alternating current generator 17 is present and a plurality of modulators 5, 6 and 7, which modulate the alternating current in dependence on the magnetic field strength ascertained by the magnetic pick-up 16 in the three different coordinate directions.

The energizing currents of the modulators 5, 6 and 7 are, possibly after amplification, fed to three mutual perpendicular energizing windings 18, 19 and 20 and currents proportional to them are fed to

EP 0 445 441 A1

compensation windings 21, 22 and 23.

De sensors 37, 38 and 39, which protrude into the mercury sphere I are connected via straight coaxial cables to the region till outside the sphere of the compensation windings 21, 22 and 23. From here they are connected to the primary coils 24, 25 and 26 of upwardly transforming auxiliary transformers 27, 28 and 29, the secondary windings of which are connected with the primary windings 30, 31 and 32 of an adding transformer 33 preferably carried out as an annular transformer, which windings mostly contain only one turn.

The secondary winding of the adding transformer via a band pass filter 34 is connected to a phase sensitive demodulator 35, which receives its phase indication from an element 36, to which a voltage derived from the energizing currents is fed.

Because the measuring voltage generated by the rotation is proportional to the field strength of the magnet field and possible pick-up voltages in the conductors are proportional to the first derative of the magnet field, phase sensitive demodulation is a very efficacious means to eliminate disturbing signals picked up from the generated alternating field.

The use of an energizing field with different frequencies is specially important, if the application of the invention is used, in which the magnet field is fixedly connected to the system, such as is the case with the known technic according to the report of R.E. Weber, mentioned in the opening part of the specification. Then it is possible to discern between the three mutually perpendicular signals and a device is obtained, which measures the angular rate about three axes moving with the system, which in the whole is considerably simpler than three separate mutually perpendicular mounted devices as described in said report.

The combination of energizing coils 18, 19, 20 and compensation coils 21, 22, 23 enables the obtention of a homogenous field inside the energizing windings and outside the compensation windings a field zero. This prevents picking up of voltages, which derive from the field generated by the energizing windings and which could form a serious disturbance if no compensation windings were present, specially at low frequencies of the angular rate to be measured. In the co-pending application "Shielded magnetisation device and angular rate sensor in which such a device has been used" based on the same priority application as the present application, this has been further elucidated.

## Claims

1. Angular rate sensor for a movable system provided with an electrically conducting inertial mass (3) through which an almost homogeneous magnet field passes, which mass is rotatable with respect to the system but translatively fixedly connected to it, wherewith at least one pair of electrodes (4,2) contact said mass, which electrodes are fixedly connected to the system and are spaced apart by a distance, the electrode vector, and by means of conductors are connected to a receiving device, characterized in that the magnet field has a direction in space, which is independent of the angular position in space of the system.

2. Angular rate sensor according to claim 1, characterized in that it contains three or more electrode pairs (37,38,39) which together form the base of a three-dimensional space.

3. Angular rate sensor according to claim 2, characterized in that there are three electrode pairs,the vectors of which are mutually perpendicular.

4. Angular rate sensor according to claim 1, 2 or 3, characterized in that the inertial mass consists of a liquid in a spherical vessel.

5. Angular rate sensor according to claim 4, characterized in that the liquid is mercury.

6. Angular rate sensor according to claim 3, 4 or 5, characterized in that one (4) of the electrodes of each pair is near to the centre of the sphere and the other near to the wall of the sphere.

7. Angular rate sensor provided with an electrically conducting liquid mass, which can rotate with respect to a movable system, but translatively is fixedly connected to it, members (x',y',z') for generating a magnet field fixedly connected to the system and at least one electrode pair, the electrodes of which are spaced apart in space by a distance, the electrode vector, characterized in that the liquid mass has the shape of a sphere, that at least three electrode pairs (37,38,39) are present and that of each pair

6

one electrode is near to the centre of the sphere and one near to the wall of the sphere.

8. Angular rate sensor according to one or more of the preceding claims 3-7, characterized in that the electrodes have an identical configuration and that means (33,34,35,36) are provided to add scalarly the voltage difference between the electrodes of each electrode pair.

9. Angular rate sensor according to one or more of the preceding claims, characterized in that the magnetic field has the direction of the earth magnet field.

10. Angular rate sensor according to claim 9, characterized in that the system is fixedly connected to a magnetic probe (x,y,z) for measuring three mutually perpendicular components of the earth field and in that the angular rate sensor is provided with magnetic energizing means (x',y',z') generating a magnetic field in the inertial mass having the same direction as the earth field.

11. Angular rate sensor according to claim 7 or 10, characterized in that the generated field is an alternating field.

12. Angular rate sensor according to one or more of the preceding claims, characterized in that conductors connecting the electrodes to the primary winding of a transformer are coaxially realized in the in the measuring device as well as in this primary winding.

fig. 1

fig.2

fig.3

fig.4

fig.5

fig. 6

European
Patent Office

EUROPEAN SEARCH
REPORT

Application Number

EP 90 20 3442

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | NL-A-6 604 335 (PNEUMODYNAMICS CORP.) <br> * Page 1, line 1 - page 3, line 10; page 4, line 1 - page 10; line 26; claims; figures * | 1,2,3,4,5, 8,9,10,12 | G 01 P 5/08 <br> G 01 C 19/14 |
| D,Y | US-A-3 641 816 (COMPAGNIE DES COMPTEURS) <br> * Entire document * | 1,2,3,4,5, 8,9,10,12 | |
| D,A | US-A-4 270 387 (THE SINGER CO.) <br> * Entire document * | 1,4,7 | |
| A | US-A-4 188 576 (P.L. JACOBS) <br> * Entire document * | 1,4,7 | |
| A | FR-A-2 462 710 (AGENCE NATIONALE DE VALORISA-TION DE LA RECHERCHE) <br> * Page 1, lines 1-16; page 1, line 34 - page 9 * | 1,2,3,5,7, 8 | |
| D,A | GB-A-1 219 890 (H.H. HERMAN) <br> * Entire document * | 1,2,3,4,5, 7 | |
| A | US-A-4 015 471 (L.B. MARSH) <br> * Entire document * | 1,2,3,7,8 | TECHNICAL FIELDS SEARCHED (Int. Cl.5) <br><br> G 01 P 5/00 <br> G 01 C 19/00 <br> G 01 C 9/00 |

The present search report has been drawn up for all claims

| Place of search | Date of completion of search | Examiner |
|---|---|---|
| The Hague | 19 April 91 | BROCK T.J. |